# EUROPEAN PATENT SPECIFICATION

(11) **EP 1 905 086 B1**
(45) Date of publication and mention of the grant of the patent: **16.01.2013**
(21) Application number: 06769167.5
(22) Date of filing: 04.07.2006
(51) Int. Cl.: H01L 45/00, C01B 13/34, C01F 17/00

(54) **METHOD FOR FORMING MULTI-LAYERED BINARY OXIDE FILM FOR USE IN RESISTANCE RANDOM ACCESS MEMORY**
VERFAHREN ZUM BILDEN EINES MEHRSCHICHTIGEN BINÄROXIDFILMS ZUR VERWENDUNG IN WIDERSTANDS-DIREKTZUGRIFFSSPEICHER
PROCEDE DE FORMATION DE FILM D'OXYDE BINAIRE MULTICOUCHE POUR MEMOIRE RAM A RESISTANCE

(30) Priority: 04.07.2005 KR 20050059830
(43) Date of publication of application: 02.04.2008
(73) Proprietor: IUCF-HYU (Industry-University Cooperation Foundation Hanyang University), Seoul 133-701 (KR)
(72) Inventor: HONG, Jin-Pyo, Seoul 133-778 (KR); DO, Young-Ho, Seoul 138-040 (KR); YOON, Kap-Soo, Seoul 133-791 (KR); JEONG, Koo-Woong, Choongchungnam-do 314-090 (KR)
(74) Representative: Powell, Timothy John
(86) International application number: PCT/KR2006/002610
(87) International publication number: WO 2007/004843

(56) References cited:
- JP-A- 2001 247 714
- US-A- 5 286 994
- US-B1- 6 235 572
- BAEK I G ET AL: "Highly scalable non-volatile resistive memory using simple binary oxide driven by asymmetric unipolar voltage pulses", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE, 13 December 2004 (2004-12-13), pages 587-590, XP010788855, DOI: 10.1109/IEDM.2004.1419228 ISBN: 978-0-7803-8684-6
- GIBBONS J F ET AL: "SWITCHING PROPERTIES OF THIN NIO FILMS", SOLID STATE ELECTRONICS, ELSEVIER SCIENCE PUBLISHERS, BARKING, GB, vol. 7, 1 January 1964 (1964-01-01), pages 785-797, XP000867660, ISSN: 0038-1101, DOI: 10.1016/0038-1101(64)90131-5
- KOZICKI M N ET AL: "Non-volatile memory based on solid electrolytes", NON-VOLATILE MEMORY TECHNOLOGY SYMPOSIUM, 2004 ORLANDO, FL, USA 15-17 NOV. 2004, PISCATAWAY, NJ, USA,IEEE, US, 15 November 2004 (2004-11-15), pages 10-17, XP010759099, DOI: 10.1109/NVMT.2004.1380792 ISBN: 978-0-7803-8726-3

## Description

### Technical Field

The invention relates to a method for growing a multi-layered binary oxidation film for use in a Resistance Random Access Memory (ReRAM), and more particularly, a method for growing a binary oxidation film with excellent uniformity and reproducibility.

### Background Art

With rapid developments in mobile, digital information communication and electronic industries, researches on devices based on the conventional charge control approach are expected to face limitations in several years. In other words, there has been a demand for a memory device based on a new concept and function rather than on the concept of the conventional electronic charge devices which have been applied for most of the twentieth century.

There is a possibility that the current PC-centered market structure will be shifted to a non-PC-centered one, which means capacity expansion of memories of major information apparatuses. In this regard, there is a need for developing an original technology for the next-generation, large-capacity, extra low-power memory device.

Flash memory, which is the most representative of nonvolatile memory, requires high operational voltage to write or erase data. Therefore, in case when the gate length is decreased to 65nm or less, adjacent cells may be operated, thus causing confusion between cells, which raises a question whether the actual realization is possible. In addition, sufficient device margin is not ensured when operated at low voltage required for low-power consumption. Therefore, there is a need for research on the next-generation nonvolatile memory.

Resistance Random Access Memory (hereinafter, referred to as ReRAM ) is a nonvolatile memory device based on drastic resistance change in a thin film with particular voltage applied to the thin film. Other nonvolatile memories have limitations. For example, DRAM is limited in scale-down (decrease in the gate length), FRAM is unstable in its material, flash memory exhibits low speed and high power consumption, and MRAM entails a complex process, multi-layer structure and small read/write margin.

On the other hand, ReRAM has excellent characteristics such as infinite recording and reproduction, operability at high temperature, and nonvolatile characteristics ensuring safety of data. Also, it can operate at high speed of 10 to 20ns (nanoseconds) and can achieve high integration and speed since it is a single-film structure in terms of process. It is manufactured basically as a single-layer structure, which can be conducted by CMOS and integration processes, thereby minimizing energy consumption.

Korean Patent Application No. 2004-0080999 discloses a method of applying a PCMO thin film for use in ReRAM. The application method includes forming a barrier layer in a thickness of 10 to 100nm, depositing a layer of iridium on the barrier layer, spin coating a layer of PCMO (Pr_{0.7}Ca_{0.3}MnO₃) on the iridium, baking the PCMO and substrate in a three-step baking process, post-baking annealing the substrate and the PCMO in a RTP chamber, repeating the spin coating, baking and annealing steps until the PCMO has a desired thickness, annealing the substrate and PCMO, and depositing a top electrode and complete the ReRAM device.

Such a manufacturing process of the PCMO thin film entails a complicated process, and transfer from vacuum to atmospheric conditions, which may affect the characteristics of ReRAM due to oxidation and surface contamination. Thus, the method is difficult to achieve excellent reproducibility and to maintain a uniform composition of PCMO material.

Therefore, there has been a demand for a method that is simple and practical for various applications and is capable of manufacturing a nonvolatile memory device without potential surface contamination.

Baek I.G. et al, "Highly scalable non-volatile resistive memory using simple binary oxide driven by asymmetric unipolar voltage pulses", Electron Devices Meeting, 2004. IEDM Technical Digest. IEEE International, San Francisco, CA, USA Dec 13-15, 2004, p.587-590, (2004), XP01788855 discloses characteristics of binary Transition Metal oxide Re RAMs.

Gibbons J.F. et al, "Switching Properties of Thin NiO Films", Solid-State Electronics, vol. 7, p.785-797, (1964), XP000867660 describes the switching action experimentally observed in thin film Nickel oxide solid-state switches.

Kozicki M.N. et al, "Non-Volatile Memory Based on Solid Electronics", Non-Volatile Memory Technology Symposium, 2004 Orlando, FL, USA 15-17 Nov. 2004, p.10-17, (2004), XP10759099 relates to the operational principles of Programmable Metallization Cell memories and presents experimental observations.

### Disclosure of Invention

### Technical Problem

The present invention has been made to solve the foregoing problems of the prior art and therefore an object of certain embodiments of the present invention is to provide a method for forming an oxidation film for use in a ReRAM in a simple process without a problem of surface contamination.

### Technical Solution

According to an aspect of the invention for realizing the object, there is provided a method for forming a multi-layered binary oxide film for use in a resistance random access memory, comprising steps of:

(i) forming a lower electrode layer on a substrate;

(ii) forming a metal layer on the lower electrode layer in a vacuum atmosphere;

(iii) oxidizing the metal layer into a binary oxide film in a vacuum atmosphere;

(iv) repeating the steps (ii) and (iii) to form a desired thickness of multi-layered binary oxide film; and

(v) forming an upper electrode layer on the multi-layered binary oxide film.

In the present invention, it is preferable that the lower electrode layer and the upper electrode layer are made of one selected from a group consisting of Pt, Au, Al, Cu, Ti and alloys thereof. It is preferable that the metal layer is made of one selected from a group consisting of Al, Co, Ni, Fe, Ta, Ti, Au, Pt, Ag and alloys thereof. Preferably, the metal layer has a thickness ranging from 0.5 to 10 nm (5 to 100Å) and more preferably, 0 to ∼ 5 nm (0~50Å)

In the present invention, the step (iii) comprises remote oxidation with 0% to 90% of Ar gas and 10% to 100% of O₂ gas, with RF plasma at an output of 30W to 200W.

It is preferable that the multi-layered binary oxidation film is annealed at a temperature ranging from 100°C to 1000°C for 1 minute to 24 hours.

### Advantageous Effects

According to the present invention, a metal layer is formed and oxidized in a vacuum atmosphere, and thus a binary oxide film can be formed in multi-layers in a simple process without potential surface contamination. The multi-layered binary oxide film can be applied to a nonvolatile memory device such as a resistance random access memory to realize a nonvolatile memory device that is more efficient than the conventional Perovskite structure and has excellent reproducibility and is effective for mass production.

### Brief Description of the Drawings

The above and other objects, features and other advantages of the present invention will be more clearly understood from the following detailed description taken in conjunction with the accompanying drawings, in which:

FIG. 1 illustrates a method for growing a multi-layered binary oxidation film according to the present invention.

FIG. 2 illustrates an exemplary apparatus for remote oxidation in the present invention.

FIG. 3 illustrates resistance change in a non-volatile memory, in which (a) is a graph showing the characteristics of the memory according to the present invention, and (b) is a graph showing the characteristics of the conventional memory.

### Best Mode for Carrying Out the Invention

The present invention now will be described more fully hereinafter with reference to the accompanying drawings, in which preferred embodiments of the invention are shown. The invention may, however, be embodied in many different forms and should not be construed as limited to the embodiments set forth herein. Rather, these embodiments are provided so that this disclosure will be thorough and complete, and will fully convey the scope of the invention to those skilled in the art. In the drawings, the shapes and dimensions are exaggerated for clarity, and the same reference numerals are used throughout to designate the same or similar components.

The present invention aims to form a metal layer and binary oxide film in a vacuum atmosphere thereby to obtain a ReRAM. According to the invention, since the metal layer is formed and oxidized in a vacuum atmosphere, the binary oxide film is not exposed to an atmospheric condition, thus without potential surface contamination. It is preferable to conduct oxidation process by remote oxidation in the present invention.

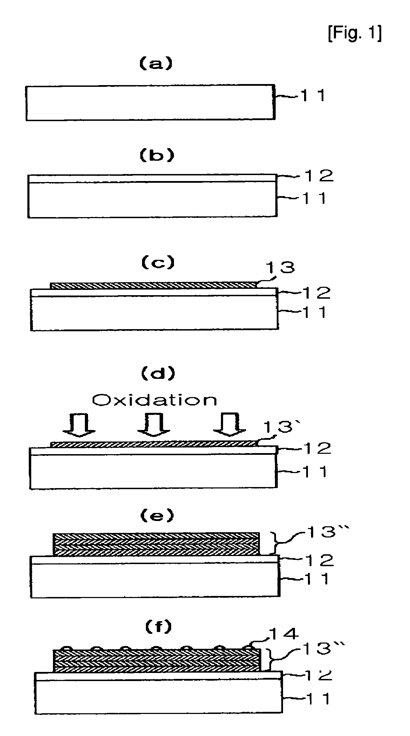

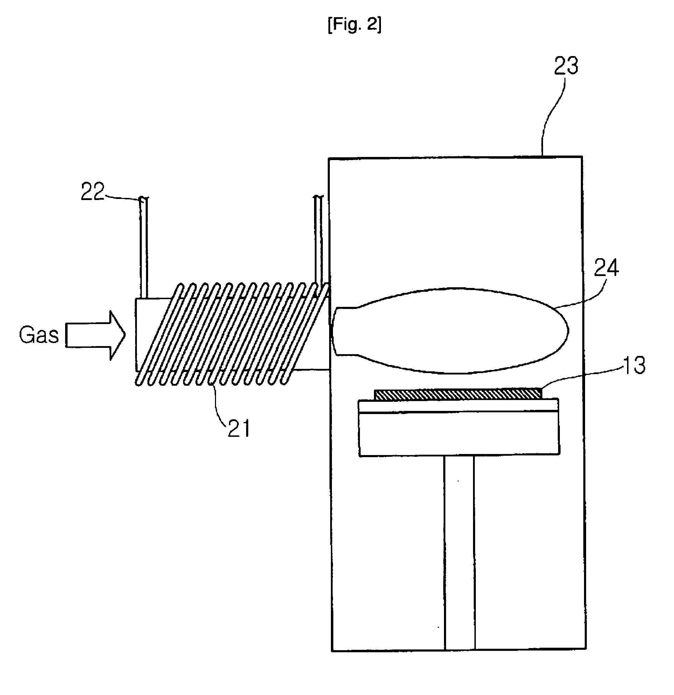

The steps of forming a multi-layered film will now be explained with reference to FIGS. 1 and 2.

First, a substrate 11 is prepared (see FIG. 1(a)).

The substrate 11 can be any kind that is typically applied to a semiconductor memory device and is not limited to a particular kind. The most representative example is a Si substrate including a silicon dioxide substrate and a poly silicon substrate.

Then a lower electrode layer 12 is formed on the prepared substrate 11 (see FIG. 1(b)).

The electrode layer is made of one selected from a group consisting of Pt, Au, A1, Cu, Ti and alloys thereof, which however does not limit the present invention. It is preferable that the electrode layer has a thickness of about 5nm to 500nm depending on the kind of electrode material. The lower electrode layer can be formed by plating or deposition.

Then, a metal layer 13 is formed on the lower electrode layer 12 (see FIG. 1(c)).

A method for forming a metal layer 13 in a vacuum atmosphere is used to form the metal layer 13. That is, methods of depositing and growing a metal layer in a vacuum atmosphere can be adopted, and such methods include Physical Vapor Deposition (PVD), Chemical Vapor Deposition (CVD), etc. Any type of metal layer suitable for ReRAM can be adopted. The most representative example of metal layer can be made of one selected from a group consisting of Al, Co, Ni, Fe, Ta, Ti, Au, Pt, Ag and alloys thereof, which however does not limit the present invention. It is preferable that the metal layer has a thickness of 0.5 to 10 nm (5Å to 100Å). Too large a thickness of the metal layer renders the later oxidation process difficult. Too small a thickness of the metal layer can affect the characteristics of the device. More preferably, the metal layer has a thickness of 1 to 5nm (10Å to 50Å) and most preferably, the metal layer has a thickness of 2 to 4 nm (20Å to 40Å).

The metal layer 13 formed on the substrate 11 is oxidized into a binary oxide film 13' in a vacuum atmosphere (see FIG. 1(d)). Any kind of oxidation process suitable for oxidizing a metal layer in a vacuum atmosphere can be adopted. The most preferable example is remote oxidation.

FIG. 2 illustrates a process of applying remote oxidation. In remote oxidation, O₂ gas is flown to collide into a coil 21 with remote plasma source 22 running therethrough to be ionized, entering the chamber 23 to form oxygen plasma. The metal layer 13 is oxidized by this oxygen plasma. Compared with a general oxidation method, remote oxidation has advantages in that it facilitates control of the thickness of the metal layer, and control of the composition of the oxide film. It is preferable that the entire surfaces of the metal layer are oxidized including its thickness direction.

According to the present invention, remote oxidation can be conducted with O₂ gas. More preferably, a predetermined amount of Ar gas is mixed with O₂ gas. The mix ratio is O₂ gas: 10-100% to Ar gas: 0-90%. More preferably, the ratio is O₂ gas: 50-80% to Ar gas: 20-50% for stable ionization of O₂.

For remote oxidation, RF can be adopted as the remote plasma source according to the present invention. The output range of the RF can be 30W to 200W and the most preferable output range is 30W to 100W in order to facilitate ionization of the gas and prevent damage to the film.

The step of forming the metal layer (FIG. 1(c)) and the step of oxidizing the metal layer (FIG. 1(d)) are repeated until a desired thickness of a multi-layered binary oxide film 13° (FIG. 1(e)) is obtained. Each of the steps of forming and oxidizing the metal layer can be conducted once. Also as shown in FIG. 1(e), the steps can be repeated at least two times each to form a multi-layered structure. In the present invention, the steps of forming the metal layer and oxidizing the metal layer can be conducted in the same chamber. Alternatively, the steps can be conducted in different chambers while transfer between the chambers is conducted in a vacuum condition.

Then, the substrate with the binary oxide film formed thereon as described above is annealed. It is preferable that annealing is conducted at a temperature ranging from 100°C to 1000°C in a vacuum or oxygen atmosphere for about 1 minute to 24 hours. Preferably, the substrate with the binary oxide film is annealed at a temperature ranging from 500°C to 700°C for 30 minutes to 3 hours in order to deliver sufficient amount of heat energy needed for rearrangement of lattice in the film.

An upper electrode layer (pattern) 14 is formed on the annealed multi-layered binary oxide film (FIG.1(f)). The upper electrode layer is made of one selected from a group consisting of Pt, Au, Al, Cu, Ti and alloys thereof, which however does not limit the present invention.

It is preferable that the upper electrode layer has a thickness of 5nm to 500nm. The upper electrode layer can be formed by plating, etc. and can be formed in a vacuum atmosphere. The upper electrode layer is formed in patterns using a shadow mask or dry etching processes.

The manufactured substrate can additionally be baked and post-annealed if necessary.

The multi-layered binary oxide film manufactured according to the present invention can be applied to a nonvolatile memory device. Such a memory device demonstrates low power consumption, infinite recording/reproduction, and quick rebooting of the PC and safe maintenance of a large capacity of data with its nonvolatile characteristics.

### Mode for the Invention

The present invention will now be explained in greater detail through an example.

**Example 1**

An Al thin film was grown in a thickness of 3nm (30Å) on a Pt lower electrode layer formed on a Si substrate. Using the apparatus shown in FIG. 2, Ar gas and O₂ gas were used at the ratio of 50%:50% with RF of about 60W to be ionized, thereby oxidizing the Al thin film.

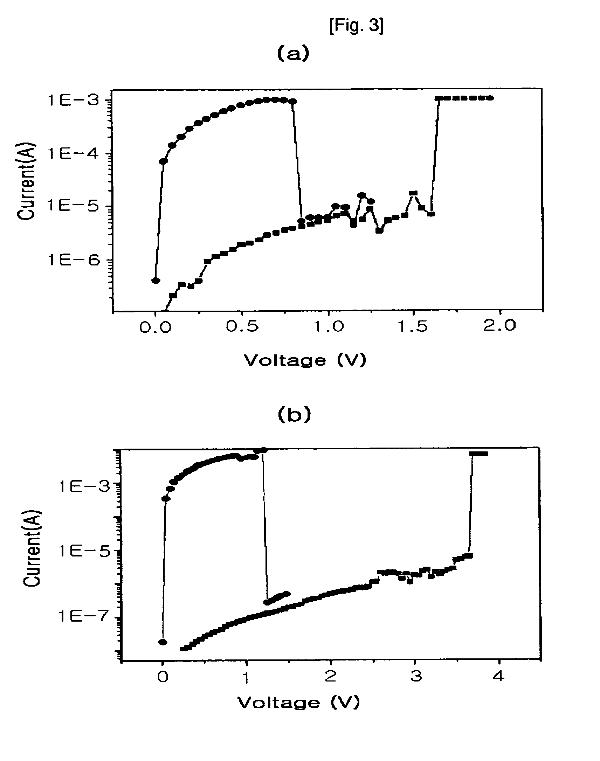

Repeating these growing and oxidizing steps of the Al thin film for 7 times to form an AlOₓ multi-layered thin film in a thickness of 21 nm (210Å). This multi-layered thin film was annealed in a vacuum condition at about 500 °C for about 30 minutes. After annealing, a Pt electrode layer was formed on the multi-layered thin film. Resistance change rate of 18000% was measured in the thin film and shown in FIG. 3(a).

On the other hand, an AlOₓ binary oxidized substance was grown in a thickness of 21 nm (210Å) on a Pt lower electrode layer, and the results are shown in FIG. 3(b).

As seen in FIGS. 3(a) and 3(b), the set voltage was improved from 3.7V with the conventional AlOx thin film to 1.65V with the present invention and the reset voltage was improved from 1.25 with the conventional AlOx thin film to 0.85 with the present invention.

While the present invention has been shown and described in connection with the preferred embodiments, it will be apparent to those skilled in the art that modifications and variations can be made without departing from the scope of the invention as defined by the appended claims.

For example, the metal layer is made of Al in certain embodiments of the invention, but can also be made of one selected from a group consisting of Co, Ni, Fe, Ta, Ti, Au, Pt and Ag.

## Claims

1. A method for forming a multi-layered binary oxide film for use in a resistance random access memory, comprising steps of:
(i) forming a lower electrode layer (12) on a substrate (11);
(ii) forming a metal layer (13) on the lower electrode layer (12) in a vacuum atmosphere;
(iii) oxidizing the metal layer into a binary oxide film (13') in a vacuum atmosphere;
(iv) repeating the steps (ii) and (iii) to form a desired thickness of multi-layered binary oxide film (13"); and
(v) forming an upper electrode layer (14) on the multi-layered binary oxide film.

2. The method according to claim 1, wherein the metal layer (13) is made of one selected from a group consisting of Al, Co, Ni, Fe, Ta, Ti, Au, Pt, Ag and alloys thereof.

3. The method according to claim 1, wherein the metal layer (13) has a thicknes ranging from 0.5 to 10 nm (5Å to 100Å).

4. The method according to claim 3, wherein the metal layer (13) has a thickness ranging from 1 to 5nm (10Å to 50Å).

5. The method according to claim 1, wherein the step (iii) comprises remote oxidation.

6. The method according to claim 5, wherein the step (iii) is conducted with 0% to 90% of Ar gas and 10% to 100% of O₂ gas.

7. The method according to claim 5, wherein the step (iii) is conducted with RF plasma at an output of 30W to 100W.

8. The method according to claim 1, wherein the multi-layered binary oxidation film is annealed at a temperature ranging from 100°C to 1000°C for 1 minute to 24 hours.

## Patentansprüche

1. Verfahren zum Bilden eines mehrschichtigen binären Oxidfilms zur Verwendung in einem Widerstandsdirektzugriffsspeicher, wobei das Verfahren die folgenden Schritte umfasst:
(i) Bilden einer unteren Elektrodenschicht (12) auf einem Substrat (11);
(ii) Bilden einer Metallschicht (13) auf der unteren Elektrodenschicht (12) in einer Vakuumatmosphäre;
(iii)Oxidieren der Metallschicht zu einem binären Oxidfilm (13') in einer Vakuumatmosphäre;
(iv) Wiederholen der Schritte (ii) und (iii), um eine gewünschte Dicke eines mehrschichtigen binären Oxidfilms (13") zu bilden; und
(v) Bilden einer oberen Elektrodenschicht (14) auf dem mehrschichtigen binären Oxidfilm.

2. Verfahren nach Anspruch 1, wobei die Metallschicht (13) aus einem Element hergestellt ist, das aus einer Gruppe bestehend aus Al, Co, Ni, Fe, Ta, Ti, Au, Pt, Ag und Legierungen davon ausgewählt ist.

3. Verfahren nach Anspruch 1, wobei die Metallschicht (13) eine Dicke aufweist, die von 0,5 bis 10 nm (5 Å bis 100 Å) reicht.

4. Verfahren nach Anspruch 3, wobei die Metallschicht (13) eine Dicke aufweist, die von 1 bis 5 nm (10 Å bis 50 Å) reicht.

5. Verfahren nach Anspruch 1, wobei der Schritt (iii) eine Remote-Oxidation umfasst.

6. Verfahren nach Anspruch 5, wobei der Schritt (iii) mit 0 % bis 90 % Ar-Gas und 10 % bis 100 % O₂-Gas durchgeführt wird.

7. Verfahren nach Anspruch 5, wobei der Schritt (iii) mit RF-Plasma mit einer Leistung von 30 W bis 100 W durchgeführt wird.

8. Verfahren nach Anspruch 1, wobei der mehrschichtige binäre Oxidations film bei einer Temperatur, die von 100 °C bis 1000 °C reicht, für 1 Minute bis 24 Stunden getempert wird.

## Revendications

1. Procédé de formation d'un film d'oxyde binaire multicouche pour une utilisation dans une mémoire vive à résistance, comprenant les étapes de :
(i) formation d'une couche d'électrode inférieure (12) sur un substrat (11) ;
(ii) formation d'une couche de métal (13) sur la couche d'électrode inférieure (12) dans une atmosphère sous vide ;
(iii) oxydation de la couche de métal en un film d'oxyde binaire (13') dans une atmosphère sous vide ;
(iv) répétition des étapes (ii) et (iii) afin de former une épaisseur souhaitée de film d'oxyde binaire multicouche (13") ; et
(v) formation d'une couche d'électrode supérieure (14) sur le film d'oxyde binaire multicouche.

2. Procédé selon la revendication 1, dans lequel la couche de métal (13) est réalisée en un élément choisi parmi un groupe constitué par Al, Co, Ni, Fe, Ta, Ti, Au, Pt, Ag et leurs alliages.

3. Procédé selon la revendication 1, dans lequel la couche de métal (13) a une épaisseur allant de 0,5 à 10 nm (5 Å à 100 Å).

4. Procédé selon la revendication 3, dans lequel la couche de métal (13) a une épaisseur allant de 1 à 5 nm (10 Å à 50 À).

5. Procédé selon la revendication 1, dans lequel l'étape (iii) comprend une oxydation à distance.

6. Procédé selon la revendication 5, dans lequel l'étape (iii) est conduite avec 0 % à 90 % de gaz Ar et 10 % à 100 % de gaz O₂.

7. Procédé selon la revendication 5, dans lequel l'étape (iii) est conduite avec du plasma RF à une puissance de sortie de 30 W à 100 W.

8. Procédé selon la revendication 1, dans lequel le film d'oxydation binaire multicouche est recuit à une température allant de 100 °C à 1 000 °C pendant 1 minute à 24 heures.
